# FASCICULE DE BREVET EUROPEEN

(11) **EP 2 215 006 B1**
(45) Date de publication et mention de la délivrance du brevet: **08.10.2014**
(21) Numéro de dépôt: 08855996.8
(22) Date de dépôt: 03.12.2008
(51) Int. Cl.: B81C 1/00

(54) **DISPOSITIF A CIRCUIT INTEGRE ET N/MEMS ENCAPSULE ET PROCEDE DE REALISATION**
VORRICHTUNG MIT INTEGRIERTER SCHALTUNG UND N/MEMS SOWIE HERSTELLUNGSVERFAHREN
DEVICE WITH ENCAPSULATED INTEGRATED CIRCUIT AND A N/MEMS AND METHOD FOR PRODUCTION

(30) Priorité: 04.12.2007 FR 0759541
(43) Date de publication de la demande: 11.08.2010
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: OLLIER, Eric, F-38100 Grenoble (FR); BARON, Thomas, F-38000 Grenoble (FR)
(74) Mandataire: Ilgart, Jean-Christophe
(86) Numéro de dépôt international: PCT/EP2008/066733
(87) Numéro de publication internationale: WO 2009/071595

(56) Documents cités:
- WO-A-01/77008

## Description

### DOMAINE TECHNIQUE

L'invention concerne le domaine des MEMS (microsystèmes électromécaniques) et/ou NEMS (nanosystèmes électromécaniques), destinés à être co-intégrés, c'est-à-dire réalisés sur un même substrat, avec des circuits intégrés, par exemple de type MOS ou CMOS. L'invention trouve notamment des applications pour la réalisation de capteurs de tout type, par exemple inertiels (accéléromètres, gyromètres), chimiques, résonants ou non, ou de résonateurs par exemple électro-mécaniques utilisés dans des applications RF (référence de temps, filtres, VCO), par exemple dans le domaine de la téléphonie mobile.

Le terme N/MEMS (nano/microsystème électromécanique) est utilisé dans la suite de ce document pour désigner un dispositif de type MEMS ou NEMS.

### ÉTAT DE LA TECHNIQUE ANTÉRIEURE

L'approche hybride, c'est-à-dire la réalisation séparée d'un N/MEMS et d'un circuit intégré tel qu'un ASIC (circuit intégré à application spécifique) puis leur assemblage sur un dispositif, permet de développer et d'optimiser séparément le N/MEMS et le circuit intégré, assurant des temps de développement courts pour chacun d'eux. Néanmoins, les performances d'un tel dispositif peuvent être limitées par les capacités parasites provenant des connexions réalisées pour relier le N/MEMS et le circuit intégré, dues notamment à la taille des plots de connexion et à la longueur des fils de connexion nécessaires. De plus, l'encombrement induit par le report d'un des deux composants sur l'autre constitue également un inconvénient. Enfin, dans cette approche, des coûts supplémentaires pour l'encapsulation (packaging) et le report s'ajoutent aux coûts de fabrication des deux composants distincts.

Par rapport à l'approche hybride, la co-intégration, c'est-à-dire l'intégration sur la même puce de structures N/MEMS et de circuits électroniques associés, permet de réduire les tailles des connexions réalisées, de simplifier l'encapsulation et l'assemblage, et d'augmenter les performances du système complet.

Il existe plusieurs types d'approche pour réaliser une co-intégration de N/MEMS avec un ou plusieurs circuits intégrés, par exemple de type CMOS, sur un même substrat :
- l'approche « pre-CMOS » : la structure du N/MEMS est définie sur le substrat avant la réalisation du dispositif CMOS,
- l'approche « intermediate-CMOS » : les étapes de réalisation du dispositif CMOS (Front-End ou Back-end, c'est-à-dire l'ensemble des étapes du procédé de fabrication CMOS mises en oeuvre respectivement avant ou après le dépôt des métallisations formant les contacts du dispositif CMOS) sont interrompues pour mettre en oeuvre les étapes de réalisation du N/MEMS,
- l'approche « post-CMOS » : la structure du N/MEMS est définie après la réalisation du dispositif CMOS.

Dans l'approche « post-CMOS », le fait que la structure du N/MEMS soit définie après la réalisation du dispositif CMOS impose des contraintes importantes sur les choix possibles des matériaux et des.étapes mises en oeuvre pour la réalisation du N/MEMS en raison des contraintes de budget thermique imposées pour ne pas détériorer le dispositif CMOS.

L'approche « intermediate-CMOS » conduit à une intégration du N/MEMS. Par rapport aux approches « post-CMOS » et « pre-CMOS », on peut réaliser le N/MEMS au plus proche du circuit CMOS en utilisant les étapes mises en oeuvre pour la réalisation du CMOS, ce qui permet d'optimiser au mieux la réalisation globale du système en réduisant les coûts pour des grandes productions, mais également de profiter des nouveaux développements dans le domaine des N/MEMS. Dans cette approche, le N/MEMS peut être réalisé soit dans la partie « Back-End », c'est-à-dire au niveau des couches d'interconnexions du dispositif CMOS, soit dans la partie « Front-End », c'est-à-dire au niveau des transistors du dispositif CMOS. On parle alors d'intégration « In-IC », ou dans le circuit intégré.

Dans ces différentes approches, il est possible de réaliser une encapsulation du N/MEMS, par exemple pour disposer le N/MEMS dans un milieu particulier (vide, gaz ou liquide) et ainsi améliorer les performances du N/MEMS (par exemple son facteur de qualité lorsque le N/MEMS est une structure résonante) et sa fiabilité (par exemple en réalisant une protection par rapport à des contaminants tels que de l'eau, des composés organiques, ...), soit par report d'un substrat supplémentaire sur le dispositif, par exemple par une étape de scellement à l'aide d'une résine, d'un scellement anodique, d'un scellement eutectique, etc., soit en utilisant une couche mince supplémentaire ajoutée.

Le document US 2006/0205106 A1 décrit un exemple d'approche « intermediate-CMOS » dans laquelle les étapes de réalisation des niveaux d'interconnexions métalliques du circuit intégré (« Back-End » du CMOS) sont également mises en oeuvre pour la réalisation et l'encapsulation d'un N/MEMS. Il s'agit d'une intégration dite « verticale », le N/MEMS étant réalisé « au-dessus » du CMOS, c'est-à-dire à un niveau supérieure au CMOS, après la réalisation de la partie « Front-End » du CMOS.

Toutefois, dans cet exemple d'intégration, le choix des matériaux formant la structure mécanique du N/MEMS est restreint puisque cette structure mécanique est obligatoirement réalisée à partir d'une ou plusieurs couches de matériau métallique formant les niveaux d'interconnexions du CMOS. Les couches sacrificielles sous et sur la structure mécanique du N/MEMS sont formées par les couches diélectriques disposées entre les d'interconnexions métalliques. Ce procédé ne permet donc pas l'utilisation de semi-conducteur, par exemple du silicium monocristallin dont les propriétés mécaniques sont intéressantes, pour la réalisation du N/MEMS. De plus, l'utilisation des métaux des couches d'interconnexions pour la réalisation du N/MEMS pose des problèmes pour le dessin (design) et la fiabilité du N/MEMS en raison des contraintes résiduelles et des hauts coefficients de dilatation thermique de ces métaux.

Le document US 6 531 331 B1 décrit un autre exemple d'approche « intermediate-CMOS » réalisant une intégration « horizontale » d'un N/MEMS au cours du procédé Front-End du CMOS. Les étapes technologiques du CMOS sont utilisées pour réaliser un N/MEMS de la manière suivante : une couche diélectrique forme à la fois une couche sacrificielle sous le N/MEMS et l'oxyde de grille du CMOS, une couche de polysilicium ou de métal forme à la fois une des couches structurelles du N/MEMS et l'électrode de grille du CMOS, et une ou plusieurs couches conductrices forment à la fois des couches structurelles du N/MEMS et des contacts de grille, de source et de drain du CMOS. Certaines couches d'interconnexions peuvent également être utilisées en tant que couches structurelles du N/MEMS. De plus, les couches sacrificielles du N/MEMS sont réalisées dans le même matériau que les couches diélectriques des interconnexions du CMOS.

Dans cet exemple d'approche « intermediate-CMOS », le choix des matériaux qui constituent la structure mécanique du N/MEMS est également restreint, et notamment ne permet pas l'utilisation de semi-conducteur monocristallin pour la réalisation du N/MEMS. De plus, étant donné qu'une ou plusieurs couches structurelles du N/MEMS sont issues de couches formant également les contacts du CMOS, il est difficile d'optimiser le recuit qui doit permettre à la fois de libérer les contraintes dans les couches de polysilicium au niveau du N/MEMS mais également de réaliser la diffusion thermique des dopants afin de créer les zones de source et drain du CMOS.

De plus, l'utilisation du polysilicium pour la partie structurelle du N/MEMS en même temps que la réalisation des contacts du CMOS ne permet pas la mise en oeuvre des technologies avancées de microélectronique permettant la réalisation de transistors très petits (canaux courts), l'obtention de densités d'intégration importantes adaptées au N/MEMS, la détection performante du déplacement dans les N/MEMS, ou encore pour obtenir des transistors performants, en particulier pour certaines applications haute fréquence (par exemple pour réaliser une base de temps incorporant un N/MEMS comportant une fréquence de résonance supérieure à environ 1 MHz ou 1 GHz).

Le document « NEMS devices for accelerometers compatible with thin SOI technology » de E. Ollier et al., IEEE-NEMS 07, Bangkok, Thailand, 16 au 19 janvier 2007, décrit un autre exemple d'approche « intermediate-CMOS » réalisant une intégration « horizontale », l'objectif étant de réaliser le circuit CMOS et le N/MEMS l'un à côté de l'autre sur deux portions différentes d'une même couche de silicium d'un substrat SOI (silicium sur isolant). Ainsi, on bénéficie des caractéristiques électriques de la couche monocristalline de silicium pour la partie CMOS et de ses caractéristiques mécaniques pour la partie N/MEMS.

Toutefois, dans le procédé décrit par ce document, le N/MEMS n'est pas protégé lorsque les étapes achevant la réalisation du circuit CMOS (réalisation des contacts, des couches d'interconnexions, ...) sont mises en oeuvre.

Un autre procédé de réalisation d'un dispositif comprenant un circuit intégré et un MEMS est décrit dans le document WO 01/77008 A1.

### EXPOSÉ DE L'INVENTION

Un but de la présente invention est de proposer un procédé de réalisation d'un dispositif à circuit intégré et N/MEMS permettant d'obtenir une structure N/MEMS intégrée sensiblement « horizontalement » au circuit intégré, ne restreignant pas le choix des matériaux à partir desquels est réalisé le N/MEMS, et ne détériorant pas le N/MEMS au cours de la réalisation du dispositif.

Pour cela, la présente invention propose un procédé de réalisation d'un dispositif comprenant au moins un circuit intégré et au moins un N/MEMS, comportant au moins les étapes de :
- réalisation du N/MEMS dans au moins une couche supérieure disposée au moins au-dessus d'une première portion d'un substrat,
- réalisation du circuit intégré dans une seconde portion du substrat et/ou dans une couche à base de semi-conducteur disposée au moins au-dessus de la seconde portion du substrat,
et comportant en outre la réalisation d'un capot encapsulant le N/MEMS à partir d'au moins une couche utilisée pour la réalisation d'une grille du circuit intégré et/ou pour la réalisation d'au moins un contact électrique du circuit intégré.

La réalisation du capot encapsulant le N/MEMS pourrait également être obtenue à partir d'au moins une couche utilisée pour la réalisation d'au moins une couche d'interconnexion du circuit intégré.

Ainsi, la structure N/MEMS est fabriquée avant ou pendant les étapes Front-End du circuit intégré qui comporte de préférence un circuit CMOS. L'encapsulation, ou packaging, du N/MEMS est réalisée à l'aide d'une couche de matériau utilisée par le procédé CMOS intervenant soit en même temps que la réalisation de la grille du ou des transistors du circuit CMOS que le circuit intégré peut comporter, ou éventuellement après cette étape, par exemple pendant la réalisation des contacts électriques ou des couches d'interconnexions.

Le N/MEMS peut notamment être réalisé en mettant en oeuvre des étapes formant également le circuit intégré, ce qui permet de réduire les coûts de fabrication du dispositif. De plus, la réalisation du capot d'encapsulation du N/MEMS à partir d'une couche utilisée pour la réalisation d'un élément du circuit intégré permet également de réduire les coûts de fabrication du dispositif.

Le capot permet d'assurer à la fois une protection mécanique lorsque les étapes achevant le circuit intégré sont mises en oeuvre, ainsi que de contrôler l'environnement du N/MEMS qui peut être disposé dans du vide, ou dans un environnement gazeux ou liquide. Ce procédé permet en outre de ne pas faire appel à une structure d'encapsulation indépendante reportée sur le N/MEMS.

Un tel procédé permet également d'utiliser un même matériau, par exemple semi-conducteur, pour le circuit intégré et le N/MEMS, ce qui est particulièrement avantageux lorsque le dispositif est réalisé à partir d'un substrat de type SOI monocristallin, le circuit intégré bénéficiant des bonnes propriétés électriques du matériau monocristallin et le N/MEMS bénéficiant des bonnes propriétés mécaniques du matériau monocristallin. De plus, cette approche peut permettre de mettre en oeuvre des moyens de détection particuliers adaptés à l'échelle nanométriques des NEMS, comme par exemple la détection par transistor latéral à grille mobile.

De façon préférentielle, la réalisation de l'encapsulation du N/MEMS utilise les étapes de réalisation de la grille du circuit intégré.

Ce procédé permet de minimiser au maximum les remises en cause du procédé CMOS, ce qui permet la mise en oeuvre des technologies de pointe actuelles de la microélectronique. Il permet en particulier de :
- faire des transistors très petits (canaux courts) pour la détection du déplacement dans le N/MEMS,
- de poursuivre l'évolution de la densité d'intégration des N/MEMS,
- de co-intégrer au N/MEMS des transistors très performants nécessaires pour certaines applications haute fréquence (par exemple une base de temps incorporant un N/MEMS dont la fréquence d'oscillation peut être supérieure à 1 MHz ou 1 GHz).

La couche supérieure peut être à base d'au moins un semi-conducteur.

La couche supérieure et la couche de semi-conducteur disposée au-dessus de la seconde portion du substrat peuvent être formées par une même couche à base de semi-conducteur.

Le circuit intégré peut comporter au moins un transistor, la grille du circuit intégré pouvant comporter au moins une grille de transistor.

Un canal du transistor peut être réalisé dans la seconde portion du substrat ou dans la couche de semi-conducteur disposée au-dessus de la seconde portion du substrat.

Le transistor peut être du type MOSFET, MESFET, bipolaire, FinFET, à triple grille, à grille enrobante, ou de type MOS latéral à grille mobile.

Le capot et la grille du circuit intégré peuvent être réalisés par des étapes de photolithographie et de gravure d'au moins une même couche à base d'un matériau électriquement conducteur.

La grille peut être à base d'au moins un métal et/ou de polysilicium.

Le capot peut être disposé sur des portions diélectriques issues d'une couche diélectrique utilisée pour la réalisation d'un oxyde de grille du circuit intégré.

La couche supérieure et/ou la couche à base de semi-conducteur disposée au-dessus de la seconde portion du substrat et/ou le substrat peuvent être à base de silicium monocristallin.

La couche de semi-conducteur disposée au-dessus de la seconde portion du substrat et/ou la couche supérieure pouvant former, avec le substrat, un substrat de type SOI, la couche de semi-conducteur disposée au-dessus de la seconde portion du substrat et/ou la couche supérieure pouvant former la couche superficielle du substrat SOI.

L'épaisseur de la couche supérieure et/ou de la couche à base de semi-conducteur disposée au-dessus de la seconde portion du substrat peut être inférieure à environ 1 µm.

Le procédé peut comporter en outre, lorsque le capot est réalisé à partir d'une couche utilisée pour la réalisation de la grille, entre l'étape de réalisation du capot et une étape de réalisation de couches d'interconnexions du circuit intégré, une étape de réalisation d'au moins une couche à base d'un matériau diélectrique sur le capot et sur le circuit intégré.

Dans ce cas, le procédé peut comporter en outre, entre l'étape de réalisation de la couche de matériau diélectrique et l'étape de réalisation des couches d'interconnexions, une étape de réalisation de contacts à base d'au moins un matériau électriquement conducteur formant des contacts électriques reliés au circuit intégré et/ou au capot et/ou au N/MEMS.

L'étape de réalisation du capot peut former également au moins un pilier entre le capot et le N/MEMS.

Le procédé peut comporter en outre, après la réalisation du N/MEMS, une étape de gravure d'une première couche sacrificielle se trouvant entre la couche supérieure et le substrat.

Le procédé peut comporter en outre, après la réalisation du capot, une étape de gravure d'une seconde couche sacrificielle se trouvant entre le capot et la couche de semi-conducteur.

Le procédé peut comporter en outre, après la réalisation du capot, une étape de gravure d'un matériau sacrificiel disposé dans des cavités formées dans le N/MEMS et/ou autour du N/MEMS.

La première couche sacrificielle et/ou la seconde couche sacrificielle et/ou le matériau sacrificiel peuvent être à base d'au moins un matériau pouvant être gravé sélectivement par rapport à la couche supérieure.

La première couche sacrificielle et/ou la seconde couche sacrificielle et/ou le matériau sacrificiel peuvent être à base d'oxyde de silicium et/ou de silicium-germanium.

La première couche sacrificielle peut comporter au moins une portion de silicium-germanium au niveau de l'emplacement du N/MEMS, le reste de la première couche sacrificielle pouvant être à base d'oxyde de silicium.

La gravure de la première couche sacrificielle et/ou la gravure de la seconde couche sacrificielle et/ou la gravure du matériau sacrificiel peuvent être réalisées à travers au moins une ouverture formée à travers le capot.

Le procédé peut comporter en outre, après la réalisation de couches d'interconnexions du circuit intégré, la réalisation d'au moins une ouverture à travers les couches d'interconnexions et le capot, formant un canal de communication entre le N/MEMS et l'environnement extérieur.

Le N/MEMS peut être réalisé par des étapes de photolithographie et de gravure dans la couche de semi-conducteur.

Les étapes de photolithographie et de gravure réalisant le N/MEMS peuvent former également des tranchées d'isolation du circuit intégré.

Le procédé peut comporter en outre, avant la réalisation du N/MEMS, une étape de gravure du substrat, formant une zone inférieure et une zone supérieure, le N/MEMS pouvant alors être réalisé au niveau de la zone inférieure et le circuit intégré pouvant être réalisé au niveau de la zone supérieure.

Dans ce cas, la face de la couche supérieure se trouvant du côté opposé au substrat peut être disposée entre un plan passant par la face du substrat au niveau de la zone supérieure et un plan passant par la face du substrat au niveau de la zone inférieure.

La présente invention concerne également un dispositif comprenant :
- au moins un N/MEMS réalisé dans au moins une couche supérieure disposée au moins au-dessus d'une première portion du substrat,
- au moins un circuit intégré réalisé dans une seconde portion du substrat et/ou dans une couche à base de semi-conducteur disposée au moins au-dessus de la seconde portion du substrat,
- un capot encapsulant le N/MEMS, à base d'au moins un matériau similaire au matériau d'une grille du circuit intégré et/ou d'au moins un contact électrique du circuit intégré.

Le capot encapsulant le N/MEMS pourrait également être à base d'au moins un matériau similaire au matériau d'au moins une couche d'interconnexions du circuit intégré.

Les avantages décrits précédemment en liaison avec le procédé de réalisation selon l'invention s'applique également à ce dispositif.

Ce dispositif permet en outre, grâce à la co-intégration réalisée, d'obtenir des signaux mesurables sur des structures de taille micrométrique ou nanométrique, permettant ainsi de réaliser des dispositifs ultra-miniatures, ayant une faible consommation, un temps de réponse rapide, une grande sensibilité aux forces extérieures ou à un ajout de masse. De plus, de très hautes fréquences de résonance peuvent être obtenues.

Ainsi, ce type de dispositif est particulièrement bien adapté pour des capteurs aux sensibilités ultimes, pour des capteurs autonomes et les systèmes fonctionnant sur batterie. De plus, ce type de dispositif peut être produit en volume à bas coût, notamment pour la production d'accéléromètres (utilisables par exemple pour la protection de disques durs, d'interfaces de téléphones portables, d'assistants personnels, de capteurs de mouvement ou encore de référence de temps).

Le capot et la grille du circuit intégré peuvent être à base d'au moins un même matériau électriquement conducteur.

Le substrat peut comporter une zone inférieure et une zone supérieure, le N/MEMS pouvant être réalisé au niveau de la zone inférieure et le circuit intégré pouvant être réalisé au niveau de la zone supérieure.

Le N/MEMS peut être disposé dans une cavité formée entre le substrat et le capot.

Le capot peut être recouvert par au moins une couche diélectrique recouvrant également le circuit intégré et à travers laquelle sont réalisés des contacts électriques reliés au circuit intégré et/ou à la couche de semi-conducteur et/ou au capot et/ou au N/MEMS, et/ou aux couches d'interconnexions également formées au dessus du circuit intégré.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un exemple de dispositif à circuit intégré et N/MEMS encapsulé, objet de la présente invention, obtenu par la mise en oeuvre d'un procédé de réalisation également objet de la présente invention,
- les figures 2A à 2D représentent les étapes d'un procédé de réalisation d'un dispositif à circuit intégré et N/MEMS encapsulé, objet de la présente invention, selon un premier mode de réalisation,
- les figures 3A à 3F représentent les étapes d'un procédé de réalisation d'un dispositif à circuit intégré et N/MEMS encapsulé, objet de la présente invention, selon un second mode de réalisation,
- les figures 4A et 4B représentent des étapes d'un procédé de réalisation d'un dispositif à circuit intégré et N/MEMS encapsulé, objet de la présente invention, selon une variante du second mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

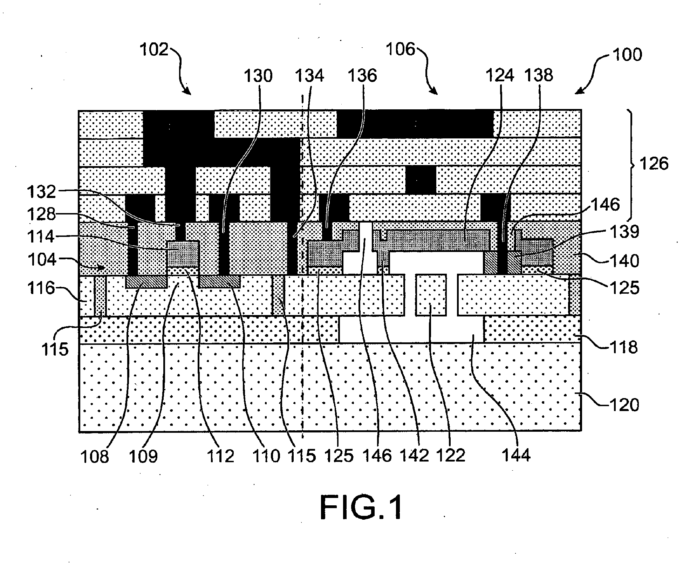

On se réfère tout d'abord à la figure 1 qui représente un exemple de dispositif 100 comportant un N/MEMS et un circuit intégré, par exemple de type CMOS.

Ce dispositif 100 comporte une première partie 102 au niveau de laquelle est réalisé le circuit intégré, ici un transistor MOSFET 104, et une seconde partie 106 au niveau de laquelle est réalisé un N/MEMS 122.

Le transistor 104 comporte au moins une source 108, un canal 109, un drain 110, un oxyde de grille 112 et une grille 114. Les sources 108 et drain 110 sont réalisés dans une couche de semi-conducteur 116, par exemple à base de silicium monocristallin, formant la couche superficielle d'un substrat SOI comportant également une couche diélectrique 118, par exemple à base d'oxyde de silicium, et un substrat de base 120 pouvant être à base de silicium. Les sources 108 et drain 110 sont réalisés par exemple par une implantation localisée de dopants dans la couche supérieure de silicium 116. Des tranchées d'isolation 115 sont également réalisées dans la couche supérieure de silicium 116.

De préférence, la couche supérieure 116 est une couche mince (épaisseur inférieure à environ 1 µm) ou ultra-mince (épaisseur inférieure à environ 100 nm). Ainsi, il est possible de réaliser des circuits intégrés à transistor à appauvrissement total (Fully Depleted) ou partiel (Partially Depleted).

Dans une variante de réalisation, le dispositif 100 peut également être réalisé à partir d'un substrat « bulk », comportant une seule couche de semi-conducteur, par exemple à base de silicium monocristallin, ou encore à partir d'un substrat de type SON (silicium sur rien, une couche supérieure de silicium étant séparée d'un substrat de base par une couche de SiGe pouvant être localement enlevée).

Le N/MEMS 122 est réalisé dans la couche supérieure de silicium 116, et est recouvert par un capot 124 laissant le N/MEMS 122 libre de mouvement. Dans l'exemple de la figure 1, le capot 124 et la grille 114 du transistor 104 sont réalisées lors d'une seule et même étape. Le capot 124 et la grille 114 sont donc à base du même matériau électriquement conducteur. Le capot 124 permet de séparer le N/MEMS 122 de niveaux d'interconnexions 126 du transistor 104. Dans ce premier mode de réalisation, le capot 124 et la grille 114 peuvent être obtenus à partir d'au moins un métal et/ou de polysilicium. Ils peuvent également être obtenus à partir de plusieurs couches à base d'au moins un matériau apte à la réalisation du capot 124 et de la grille 114. De plus, sur l'exemple de la figure 1, le capot 124 est disposé sur des portions diélectriques 125 issues de la couche de matériau diélectrique utilisée pour former l'oxyde de grille 112 du transistor 104.

Les niveaux d'interconnexions 126 sont ici formés par des couches diélectriques (par exemple à base de dioxyde de silicium ou de nitrure) dans lesquelles sont réalisées des portions à base de matériau électriquement conducteur tel que du métal, par exemple de l'aluminium et/ou du cuivre, et/ou de silicium polycristallin. Ces niveaux d'interconnexions 126 peuvent permettre en outre de réaliser une protection du N/MEMS 122 vis-à-vis de la lumière extérieure en plus du capot 124.

Le dispositif 100 de la figure 1 comporte en outre plusieurs éléments de connexions électriques :
- un premier contact électrique 128 relié à la source 108,
- un second contact électrique 130 relié au drain 110,
- un troisième contact électrique 132 relié à la grille 114,
- un quatrième contact électrique 134 relié à la couche supérieure 116.

Chaque contact électrique est relié à l'une des couches d'interconnexions 126, les rendant ainsi accessibles depuis l'extérieur du dispositif 100.

Un ou plusieurs contacts électriques (un seul contact 136 est représenté sur la figure 1) relient électriquement le capot 124 à l'une des couches d'interconnexions 126. De plus, un ou plusieurs contacts électriques (un seul contact 138 est représenté sur la figure 1) réalisent la liaison électrique depuis le N/MEMS 122 vers au moins l'un des niveaux d'interconnexions 126 et/ou vers le transistor CMOS 104. Dans l'exemple de la figure 1, le contact 138 est réalisé à travers une portion 139 à base d'un matériau diélectrique disposée sur le N/MEMS 122.

Sur l'exemple de la figure 1, le dispositif 100 comporte une couche diélectrique 140 réalisée sur la couche supérieure de semi-conducteur 116, recouvrant le transistor 104 et le capot 124 et les isolant ainsi des couches d'interconnexion 126. De plus, cette couche diélectrique i40 englobe les parties des contacts électriques 128, 130, 132, 134, 136, 138 se trouvant sous les couches d'interconnexions 126. Cette couche diélectrique 140 est dans cet exemple à base de dioxyde de silicium ou de nitrure de silicium.

Il est possible que le dispositif 100 comporte également un ou plusieurs piliers 142, réalisant un soutien mécanique du capot 124 pour éviter qu'il se déforme ou s'effondre dans une cavité 144 dans laquelle est réalisée le N/MEMS 122 sous l'effet de contraintes appliquées (contraintes matériaux, contraintes induites par la technologie des interconnexions, pression extérieure, packaging ...).

Durant la réalisation du dispositif 100, le N/MEMS 122 est libéré par une gravure d'une ou plusieurs couches sacrificielles sur et/ou sous lesquelles est réalisé le N/MEMS 122, permettant de séparer le N/MEMS 122 du capot 124 et du substrat de base 120. Sur l'exemple de la figure 1, le N/MEMS 122 est libéré de la couche d'oxyde 118 et du substrat 120 par gravure à travers un ou plusieurs trous verticaux, ou ouvertures, 146 réalisés ici à travers le capot 124. La ou les couches sacrificielles peuvent également être à base de silicium-germanium, notamment lorsque le substrat utilisé est de type SON, la couche supérieure étant alors à base de silicium monocristallin obtenu par épitaxie à partir de la couche de silicium-germanium elle-même épitaxiée sur le substrat de base de silicium.

Dans le cas d'un substrat de type SOI, comme c'est le cas sur la figure 1, la libération du N/MEMS 122 se fait par gravure avec arrêt au temps. La distance libérée est dans ce cas dépendante de la géométrie de la structure du N/MEMS 122. Il en est de même dans le cas d'une libération du N/MEMS 122 vis-à-vis du capot 124 dans le cas de couches sacrificielles à base d'un même matériau, par exemple du dioxyde de silicium comme sur l'exemple de la figure 1. Dans ce cas, on peut répartir de manière sensiblement régulière les trous 146 sur l'ensemble du capot 124 en fonction de la structure du N/MEMS 122. Dans le cas où deux couches sacrificielles de nature différentes sont utilisées, il est possible de mettre des trous 146 du capot 124 en périphérie du capot 124 et du N/MEMS 122, faire une libération complète de la première couche sacrificielle, sans contrainte de temps et de contrôle de distance de libération, puis de faire une seconde libération, de la seconde couche sacrificielle. Dans tous les cas, les trous de libération réalisés dans le capot 124 peuvent être rebouchés par un matériau approprié, par exemple du dioxyde de silicium et/ou du nitrure et/ou du silicium et/ou du métal. Ce matériau de rebouchage peut également être issu d'une couche déposée lors de la réalisation d'un élément du transistor 104 (matériau des contacts, des couches d'interconnexions, ...).

Le dispositif 100 peut également comporter au moins un canal, non représenté sur la figure 1, mettant en communication le N/MEMS 122 et le milieu extérieur du dispositif 100, notamment lorsque le N/MEMS 122 est par exemple un capteur de pression ou un capteur chimique. Ce canal peut par exemple être réalisé par une ouverture formée à travers les niveaux d'interconnexions 126 et le capot 124. Pour cela, une exclusion des métaux des couches d'interconnexions 126 doit être faite au niveau de l'ouverture désirée. Une lithographie suivie d'une gravure de la couche diélectrique 140 permet alors de faire communiquer le N/MEMS 122 et l'extérieur du dispositif 100.

Dans une variante de réalisation, le transistor 104 peut être de type MESFET (transistor à effet de champ à commande Schottky), bipolaire, FinFET (transistor à effet de champ à ailettes), trigate (transistor à triple grilles), GAR (transistor à grille enrobante), etc.

Dans une autre variante, le transistor 104 peut être de type MOS latéral à grille mobile, c'est-à-dire comportant un canal perpendiculaire à un plan passant par le drain, la source et la grille, et dont la grille est mobile par rapport au drain et à la source. Dans ce cas, le transistor à grille mobile peut réaliser une transduction mécanique-électrique des mouvements du N/MEMS 122.

Dans une variante de réalisation, le capot 124 peut être obtenu à partir d'une étape de réalisation d'un élément du transistor 104 autre que la grille 114, par exemple à partir du matériau des contacts 128, 130, 132, 134, ou à partir de l'un des matériaux des couches d'interconnexions 126 (diélectrique ou conducteur).

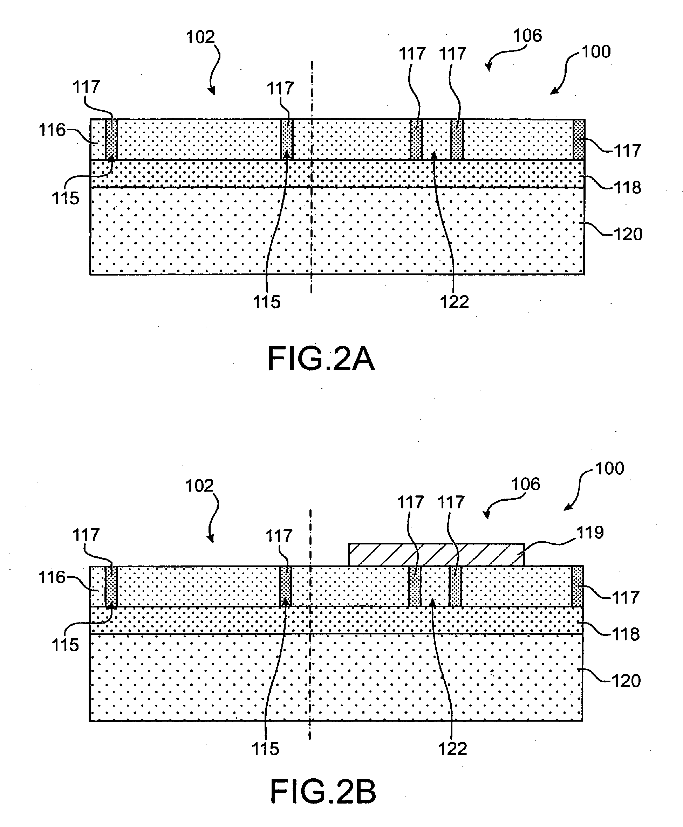

On se réfère maintenant aux figures 2A à 2D qui représentent les étapes d'un procédé de réalisation du dispositif 100 selon un premier mode de réalisation.

Comme représenté sur la figure 2A, on réalise tout d'abord une structuration de la partie mécanique N/MEMS 122 dans la couche supérieure de silicium 116 du substrat SOI formé par cette couche supérieure 116, la couche diélectrique 118 et le substrat de base 120. Dans ce premier mode de réalisation, les tranchées d'isolation 115, destinées à isoler le transistor 104 du dispositif 100, sont également réalisées dans la couche supérieure 116, au cours de cette même structuration. Le dispositif 100 comporte donc une partie 102 au niveau de laquelle va être réalisé le transistor 104, et une partie 106 au niveau de laquelle est réalisé le N/MEMS 122.

Cette structuration est par exemple réalisée tout d'abord par un dépôt d'une couche d'oxyde et d'une couche de nitrure (non représentées) sur la couche supérieure de silicium 116, destinées à former un masque dur. Une étape de photolithographie des motifs des tranchées d'isolation 115 et du N/MEMS 122 est ensuite mise en oeuvre. Les couches de nitrure, d'oxyde et la couche supérieure de silicium 116 sont gravées selon le motif précédemment photolithographié. Le motif gravé est ensuite rempli par un diélectrique 117, par exemple du Si02. On réalise ensuite un polissage mécano-chimique avec arrêt sur la couche de nitrure pour supprimer le diélectrique dépassant du motif gravé. Les couches de nitrure et d'oxyde sont alors supprimées, par exemple par gravure.

On réalise donc de préférence les tranchées d'isolation 115 et la structuration du N/MEMS 122 à partir des mêmes étapes de photolithographie et de gravure. Dans une variante, il est possible que la structuration des tranchées d'isolation 115 soit réalisée avant la structuration de la partie N/MEMS 122, ou inversement. La structuration dans la couche supérieure de silicium 116 est alors réalisée en deux temps. La structuration du N/MEMS 122 peut être réalisée avant les tranchées d'isolation 115 si les dimensions du motif à graver pour le N/MEMS 122 sont critiques par rapport à celles des tranchées d'isolation 115.

On réalise ensuite un (ou plusieurs) dopage de la couche supérieure de silicium 116. Ce (ou ces) dopage est destiné à former le canal 109 du transistor 104 et à ajuster la résistivité du matériau formant le N/MEMS 122. Ce dopage est par exemple réalisé par une étape d'implantation ionique mise en oeuvre à travers un masque à base de résine, d'oxyde, ou encore de SiGe déposé sur la couche supérieure de silicium 116, ce masque étant par exemple réalisé par une étape de photolithographie et de gravure. Au moins un recuit d'implantation permet ensuite d'activer les dopants introduits dans la couche de silicium 116 et de réduire les dislocations présentes dans cette couche.

On réalise ensuite une couche sacrificielle 119 (figure 2B), par exemple à base de dioxyde de silicium et/ou de silicium-germanium, obtenue par dépôt ou épitaxie sur la couche supérieure de silicium 116. Cette couche 119 est alors structurée en mettant en oeuvre par exemple des étapes de photolithographie et de gravure. Sur la figure 2B, seule une portion de la couche sacrificielle 119 est conservée au-dessus du N/MEMS 122.

De préférence, on réalise les étapes de dopage et de recuit avant la réalisation et la structuration de la couche sacrificielle 119. Toutefois, il est possible de d'inverser l'ordre de mise en oeuvre entre le dopage et la réalisation/structuration de la couche sacrificielle 119.

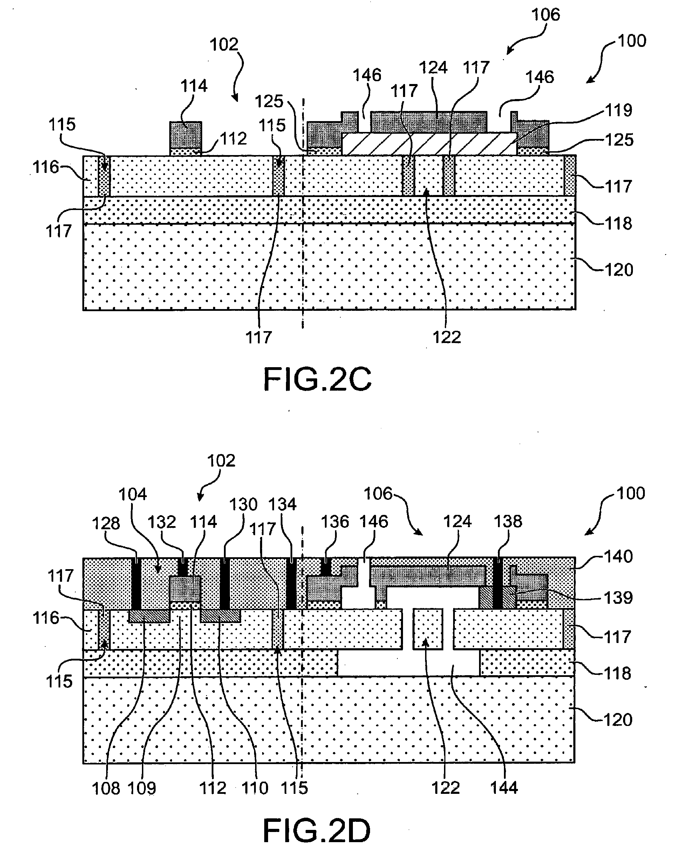

On réalise ensuite l'oxyde de grille 112 et la grille 114 du transistor 104, ainsi que le capot de protection 124 de la structure N/MEMS 122, à partir des mêmes étapes de photolithographie et de gravure, en utilisant des masques communs (figure 2C).

Pour cela, on réalise tout d'abord une oxydation thermique de la couche de semi-conducteur 116, formant sur celle-ci une couche diélectrique à base d'oxyde de silicium. Une couche, par exemple à base de polysilicium et/ou de métal, est déposée sur cette couche diélectrique. Une étape de photolithographie et une étape de gravure de la couche diélectrique et de la couche de polysilicium et/ou de métal sont alors mises en oeuvre. Une des portions restantes de la couche diélectrique forme le diélectrique de grille 112. Les portions restantes de la couche de polysilicium et/ou de métal forment la grille 114 ainsi que le capot 124 comportant dans cet exemple de réalisation des trous 146 formés par les étapes de photolithographie et de gravure. Le capot 124 est disposé sur des portions restantes 125 de la couche diélectrique gravée précédemment.

On réalise ensuite la libération du N/MEMS 122. Pour cela, on dépose tout d'abord un matériau destiné à protéger la partie 102 comportant le transistor 104. Ce matériau, par exemple un nitrure, est apte à résister aux agents de gravure qui seront utilisés ultérieurement pour graver une partie de la couche diélectrique 118 et une partie de la couche sacrificielle 119. On réalise une photolithographie et une gravure pour supprimer le matériau de protection au niveau des trous 146. La partie de la couche sacrificielle 119 liée au capot 124 et au N/MEMS 122 est alors gravée par l'intermédiaire des trous 146 précédemment formés dans le capot 124. Le matériau diélectrique 117 se trouvant au niveau du N/MEMS 122 est également gravé, ainsi qu'une partie de la couche diélectrique 118, libérant ainsi le N/MEMS 122 et formant une cavité 144 dans laquelle se trouve le N/MEMS 122.

On peut ensuite réaliser un rebouchage des trous 146 précédemment formés à travers le capot 124. Pour cela, un matériau de rebouchage, par exemple du dioxyde de silicium et/ou du nitrure et/ou du silicium et/ou du métal, est déposé sur le dispositif 100 et notamment dans les trous 146. La couche du matériau de rebouchage est alors photolithographiée et gravée pour ne conserver que les portions de ce matériau se trouvant dans les trous 146.

Le matériau protégeant la partie 102 du dispositif 100 est ensuite supprimé par gravure.

On réalise ensuite la source 108 et le drain 110 du transistor 104 par implantation ionique directe ou à travers un masque déposé au préalable. La couche de diélectrique 140 est déposée alors sur l'ensemble du dispositif 100. Les contacts 128, 130, 132, 134, 136, 138 reliés respectivement à la source 108, au drain 110, à la grille 114, à la couche supérieure 116, au capot 124 et au N/MEMS 122, sont réalisés par photolithographie et gravure de la couche diélectrique 140, formant ainsi des ouvertures dans lesquelles est déposé le ou les matériaux conducteurs utilisés pour former les contacts, par exemple du titane et/ou du platine et/ou du silicium et/ou du tungstène. Des étapes de siliciuration (par exemple de NiSi, PtSi, ...) peuvent être mises en oeuvre avant le dépôt du ou des matériaux de contact afin d'optimiser les propriétés des contacts, en particulier de réduire les résistances de contact. On supprime le matériau conducteur se trouvant en dehors des ouvertures, par exemple par photolithographie et gravure, ou planarisation mécano-chimique (voir figure 2D).

Dans une variante du procédé décrit ici, le matériau de rebouchage peut être issu d'une couche destinée à former un élément du transistor 104. Par exemple, ce matériau de rebouchage peut être le matériau déposé lors de la réalisation des contacts 128 à 138, ou encore être issu de la couche diélectrique 140. De plus, il est possible de réaliser la libération du N/MEMS 122 entre la réalisation de la source et du drain et la réalisation de la couche diélectrique 140, ou entre la réalisation de la couche diélectrique 140 et la réalisation des contacts, ou après la réalisation des contacts du dispositif 100.

De préférence, on réalisera tout d'abord l'étape d'implantation destinée à former la source et le drain, puis la réalisation de la couche diélectrique 140, puis la réalisation des contacts 128 à 138, et enfin la libération du N/MEMS 122. Ainsi, on peut conserver la couche de protection déposée pour la libération du N/MEMS, dont l'épaisseur peut être choisie par une étape ultérieure de planarisation ou de gravure.

On réalise enfin les couches d'interconnexions 126 en déposant successivement des couches de matériau diélectrique, par exemple à base d'oxyde ou de nitrure, en réalisant une photolithographie et une gravure de ce matériau diélectrique au niveau des emplacements d'interconnexions, puis en déposant un ou plusieurs matériaux, par exemple du cuivre et/ou de l'aluminium et/ou du silicium dans les emplacements gravés. Des étapes de planarisation mécano-chimique ou de photolithographie et gravure du matériau métallique sont mises en oeuvre pour localiser ce matériau aux endroits nécessaires. On obtient ainsi le dispositif 100 représenté sur la figure 1.

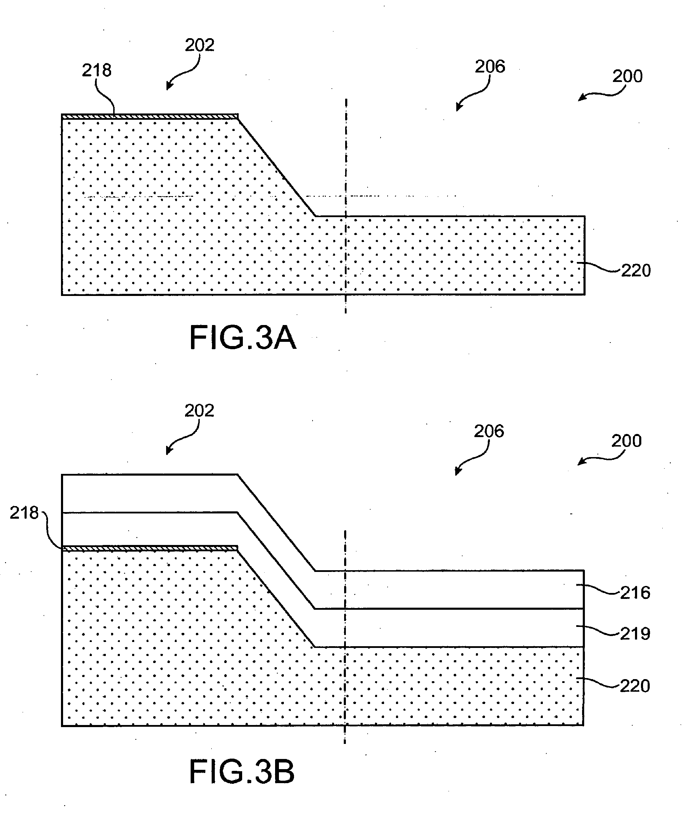

On se réfère maintenant aux figures 3A à 3F qui représentent les étapes d'un procédé de réalisation d'un dispositif 200 à circuit intégré et N/MEMS encapsulé selon un second mode de réalisation. Dans l'exemple de réalisation décrit, le dispositif comporte le N/MEMS 122 et le transistor 104 décrit précédemment en liaison avec le dispositif 100.

Dans ce second mode de réalisation, le dispositif 200 est réalisé à partir d'un substrat de silicium 220 massif (bulk). Ce substrat 220 est recouvert par une couche de protection 218 à base de diélectrique, par exemple du dioxyde de silicium ou du nitrure, formée par un dépôt. Une étape de photolithographie et une étape de gravure sèche ou humide (par exemple à base de KOH) permettent de supprimer une portion de cette couche de protection 218 se trouvant au niveau d'une zone 206 du dispositif 200 au niveau de laquelle sera réalisé le N/MEMS 122. Une partie du substrat 220, au niveau de la zone 206 du dispositif 200, est alors gravée, formant ainsi un emplacement pour la réalisation du N/MEMS 122 (figure 3A).

Une couche sacrificielle 219, par exemple à base de dioxyde de silicium ou de silicium-germanium, est alors déposée sur le substrat 220 (ainsi que sur la couche de protection 218). Une couche active 216, par exemple à base d'un semi-conducteur tel que du silicium, dans laquelle est destiné à être réalisé le N/MEMS 122, est alors déposée sur la couche sacrificielle 219. Cette couche active 216 peut notamment être à base. de silicium monocristallin lorsque la couche sacrificielle 219 est à base de silicium-germanium.

Les épaisseurs de la couche sacrificielle 219 et de la couche active 216, ainsi que l'épaisseur gravée du substrat 220 au niveau de la zone 206, sont choisies telles que la face supérieure de la couche active 216 se trouve au plus au même niveau que, ou au-dessous de, la face supérieure du substrat 220 au niveau de la zone 202 du dispositif 200 (figure 3B).

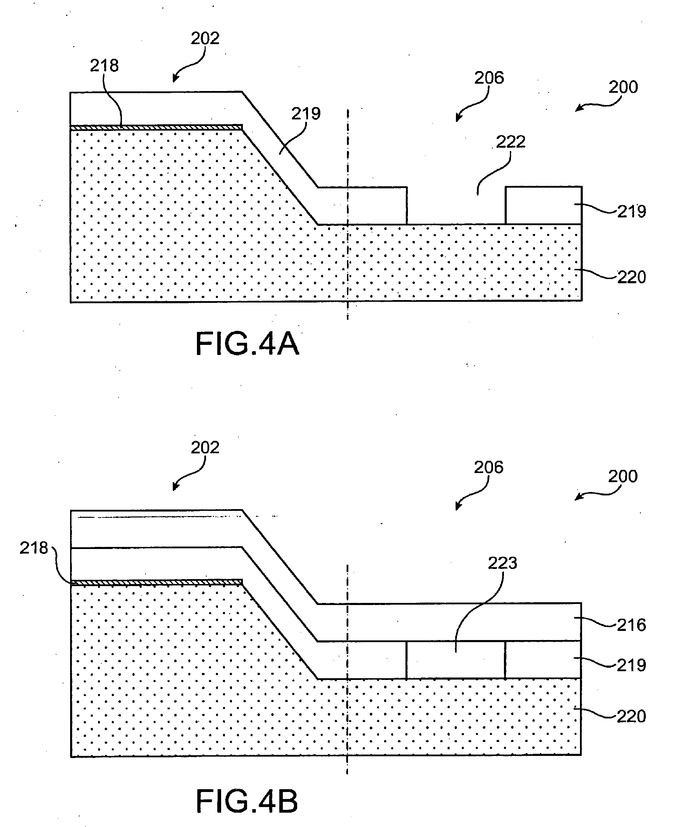

Dans une variante, afin d'isoler électriquement le N/MEMS 122 qui sera fabriqué dans la couche active 216, il est possible de réaliser une couche sacrificielle 219 à base d'un diélectrique comportant une portion sacrificielle à base de silicium-germanium disposée sous la partie active du N/MEMS 122. Pour cela, comme représenté sur la figure 4A, on dépose la couche 219 à base d'un diélectrique, par exemple du dioxyde de silicium, sur le substrat 220 et la couche de protection 218. On réalise ensuite une structuration de cette couche 219, par exemple par photolithographie et gravure, afin de former une ouverture 222 dans la couche 219 et réaliser ainsi une zone active au niveau de l'emplacement du N/MEMS 122.

On dépose ensuite, de manière sélective, une couche à base de silicium-germanium dans l'ouverture 222, formant une portion 223 de silicium-germanium dans la couche 219, puis on réalise une épitaxie de la couche active 216 (figure 4B). Lorsque la couche active 216 est à base de silicium, la portion de la couche 216 se trouvant au-dessus de la portion 223 de silicium-germanium, là où sera réalisé le N/MEMS 122, est à base de silicium monocristallin, le reste de la couche 219 étant à base de silicium polycristallin.

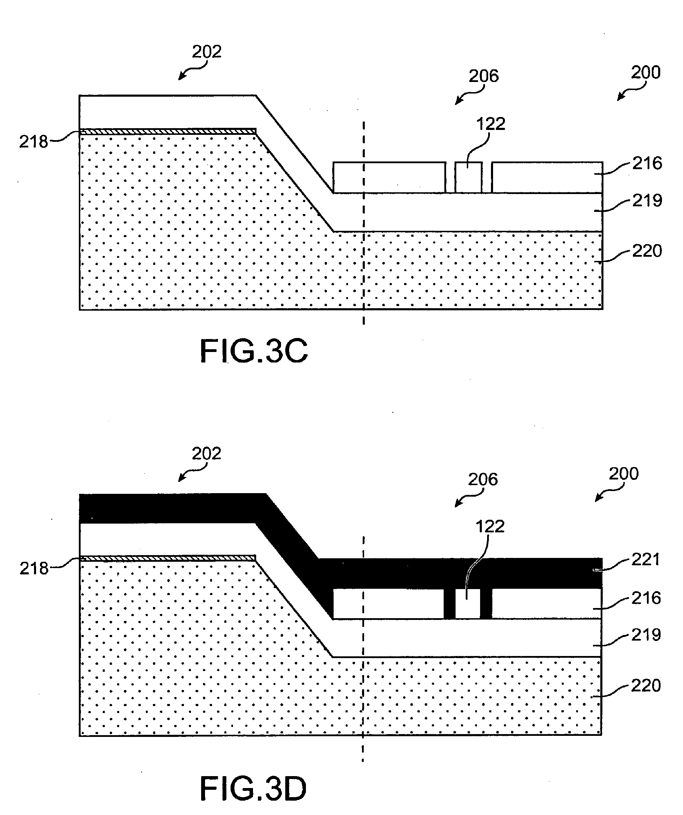

Comme représenté sur la figure 3C, on réalise ensuite une structuration de la couche active 216, pour former le N/MEMS 122. Comme dans le premier mode de réalisation, cette structuration est réalisée de manière avantageuse en même temps que la réalisation des tranchées d'isolation de la partie CMOS (ces tranchées n'étant pas représentées sur les figures 3A à 3F. Pour cela, les portions de la couche active 216 ne se trouvant pas dans la zone 206 destinée à comporter le N/MEMS 122, c'est-à-dire les portions de la couche active 216 se trouvant au niveau de la zone 202 du dispositif 200, sont supprimées par exemple par photolithographie et gravure. La portion restante de la couche active 216 est également photolithographiée puis gravée au cours de ces deux étapes pour former la structure mécanique du N/MEMS 122.

On réalise ensuite un ou des dopages par implantation ionique dans la structure mécanique du N/MEMS 122, par exemple en faisant appel à un masque dur réalisé à base d'un diélectrique tel que du dioxyde de silicium par photolithographie et gravure, comme pour le dispositif 100 décrit précédemment. Ce ou ces dopages sont aussi réalisés au niveau de la partie CMOS pour former les caissons des transistors dans lesquels seront réalisés les canaux des transistors. Après l'implantation, le dispositif 200 est soumis à un recuit, puis le masque dur est supprimé par gravure.

Comme représenté sur la figure 3D, une seconde couche sacrificielle 221 est ensuite déposée sur le dispositif 200.

La seconde couche sacrificielle 221 peut ensuite être structurée pour former par exemple des piliers destinés à soutenir le capot 124 qui encapsulera le N/MEMS 122

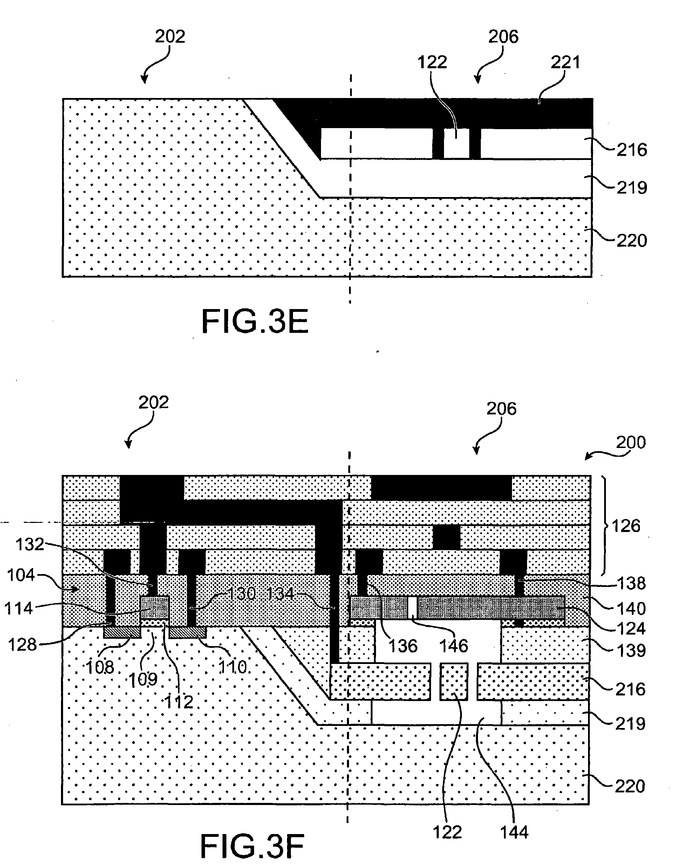

Comme représenté sur la figure 3E, on réalise ensuite une étape de planarisation mécano-chimique avec arrêt sur la couche de protection 218 afin de supprimer les portions de la seconde couche sacrificielle 221 et de la première couche sacrificielle 219 se trouvant au niveau de la zone 202 du dispositif 200. La couche de protection 218 est également supprimée, par exemple par gravure.

Sur l'exemple de la figure 3E, la face de la couche de semi-conducteur 216 se trouvant du côté opposé au substrat 220 est disposée entre un plan passant la face du substrat 220 au niveau de la zone 202 et un plan passant par la face du substrat 220 au niveau de la zone 206. Cette caractéristique est obtenue en choisissant des épaisseurs appropriées pour la couche de silicium 216 et les couches sacrificielles 219 et 221. Dans une variante, ces épaisseurs peuvent être choisis pour que la face de la couche de semi-conducteur 216 se trouvant du côté opposé au substrat 220 soit au niveau de la face du substrat 220 au niveau de la zone 202. On obtient ainsi une configuration sensiblement similaire au dispositif 100 où le transistor 104 est au même niveau que le N/MEMS 122.

Les étapes décrites en liaison avec les figures 2C à 2D et 1 (réalisation du transistor 104, réalisation du capot 124, libération du N/MEMS 122, réalisation des contacts 128, 130, 132, 134, 136, 138, réalisation des couches d'interconnexions 126), sont alors mises en oeuvre, par exemple de manière similaire au premier mode de réalisation décrit précédemment, pour achever la réalisation du dispositif 200. On obtient ainsi le dispositif 200 représenté sur la figure 3F, comportant des éléments similaires à ceux du dispositif 100 selon le premier mode de réalisation. Lorsque la couche 219 comporte une portion 223 à base de silicium-germanium, la libération du N/MEMS 122 est notamment réalisée en gravant cette portion 223 se trouvant sous le N/MEMS 122.

Dans une variante, l'étape de structuration de la couche sacrificielle 221 peut être réalisée ultérieurement à la réalisation du transistor 104.

## Revendications

1. Procédé de réalisation d'un dispositif (100, 200) comprenant au moins un circuit intégré (104) et au moins un N/MEMS (122), comportant au moins les étapes de :
- réalisation du N/MEMS (122) dans au moins une couche supérieure (116, 216) disposée au moins au-dessus d'une première portion d' un substrat (120, 220),
- réalisation du circuit intégré (104) dans une seconde portion du substrat (120, 220) et/ou dans une couche à base de semi-conducteur (116) disposée au moins au-dessus de la seconde portion du substrat (120, 220), procédé **caractérisé en ce qu'**il comporte
en outre la réalisation d'un capot (124) encapsulant le N/MEMS (122) à partir d'au moins une couche utilisée pour la réalisation d'une grille (114) du circuit intégré (104).

2. Procédé selon la revendication 1, la couche supérieure (116, 216) étant à base d'au moins un semi-conducteur.

3. Procédé selon la revendication 2, la couche supérieure (116) et la couche de semi-conducteur (116) disposée au-dessus de la seconde portion du substrat (120) étant formées par une même couche à base de semi-conducteur.

4. Procédé selon l'une des revendications précédentes, le circuit intégré (104) comportant au moins un transistor, la grille (114) du circuit intégré (104) comportant au moins une grille de transistor.

5. Procédé selon la revendication 4, un canal (109) du transistor étant réalisé dans la seconde portion du substrat (120, 220) ou dans la couche de semi-conducteur (116) disposée au-dessus de la seconde portion du substrat (120, 220).

6. Procédé selon l'une des revendications 4 ou 5, le transistor étant du type MOSFET, MESFET, bipolaire, FinFET, à triple grille, à grille enrobante, ou de type MOS latéral à grille mobile.

7. Procédé selon l'une des revendications précédentes, le capot (124) et la grille (114) du circuit intégré (104) étant réalisés à partir d'au moins une même couche à base d'un matériau électriquement conducteur.

8. Procédé selon la revendication 7, le capot (124) et la grille (114) étant réalisés par des étapes de photolithographie et de gravure de la couche de matériau électriquement conducteur.

9. Procédé selon l'une des revendications précédentes, la grille (114) étant à base d'au moins un métal et/ou de polysilicium.

10. Procédé selon l'une des revendications précédentes, le capot (124) étant disposé sur des portions diélectriques (125) issues d'une couche diélectrique utilisée pour la réalisation d'un oxyde de grille (112) du circuit intégré (104).

11. Procédé selon l'une des revendications précédentes, la couche supérieure (116, 216) et/ou la couche à base de semi-conducteur (116) disposée au-dessus de la seconde portion du substrat (120, 220) et/ou le substrat (120, 220) étant à base de silicium monocristallin.

12. Procédé selon l'une des revendications précédentes, la couche de semi-conducteur (116) disposée au-dessus de la seconde portion du substrat (120) et/ou la couche supérieure (116) formant, avec le substrat (120), un substrat de type SOI, la couche de semi-conducteur (116) disposée au-dessus de la seconde portion du substrat (120) et/ou la couche supérieure (116) formant la couche superficielle du substrat SOI.

13. Procédé selon l'une des revendications précédentes, l'épaisseur de la couche supérieure (116, 216) et/ou de la couche à base de semi-conducteur (116) disposée au-dessus de la seconde portion du substrat (120, 220) étant inférieure à environ 1 µm.

14. Procédé selon l'une des revendications précédentes, comportant en outre, entre l'étape de réalisation du capot (124) et une étape de réalisation de couches d'interconnexions (126) du circuit intégré (104), une étape de réalisation d'au moins une couche (140) à base d'un matériau diélectrique sur le capot (124) et sur le circuit intégré (104).

15. Procédé selon la revendication 14, comportant en outre, entre l'étape de réalisation de la couche (140) de matériau diélectrique et l'étape de réalisation des couches d'interconnexions (126), une étape de réalisation de contacts (128, 130, 132, 134, 136, 138) à base d'au moins un matériau électriquement conducteur formant des contacts électriques reliés au circuit intégré (104) et/ou au capot (124) et/ou au N/MEMS (122).

16. Procédé selon l'une des revendications précédentes, l'étape de réalisation du capot (124) formant également au moins un pilier (142) entre le capot (124) et le N/MEMS (122).

17. Procédé selon l'une des revendications précédentes, comportant en outre, après la réalisation du N/MEMS (122), une étape de gravure d'une première couche sacrificielle (118, 219) se trouvant entre la couche supérieure (116, 216) et le substrat (120, 220).

18. Procédé selon l'une des revendications précédentes, comportant en outre, après la réalisation du capot (124), une étape de gravure d'une seconde couche sacrificielle (119, 221) se trouvant entre le capot (124) et la couche de semi-conducteur (116, 216).

19. Procédé selon l'une des revendications précédentes, comportant en outre, après la réalisation du capot (124), une étape de gravure d'un matériau sacrificiel (117, 221) disposé dans des cavités formées dans le N/MEMS (122) et/ou autour du N/MEMS (122).

20. Procédé selon l'une des revendications 17 à 19, la première couche sacrificielle (118, 219) et/ou la seconde couche sacrificielle (119, 221) et/ou le matériau sacrificiel (117, 221) étant à base d'au moins un matériau pouvant être gravé sélectivement par rapport à la couche supérieure (116, 216).

21. Procédé selon l'une des revendications 17 à 20, la première couche sacrificielle (118, 219) et/ou la seconde couche sacrificielle (119, 221) et/ou le matériau sacrificiel (117, 221) étant à base d'oxyde de silicium et/ou de silicium-germanium.

22. Procédé selon la revendication 21, la première couche sacrificielle (219) comportant au moins une portion de silicium-germanium au niveau de l'emplacement du N/MEMS (122), le reste de la première couche sacrificielle (219) étant à base d'oxyde de silicium.

23. Procédé selon l'une des revendications 17 à 22, la gravure de la première couche sacrificielle (118, 219) et/ou la gravure de la seconde couche sacrificielle (119, 221) et/ou la gravure du matériau sacrificiel (117, 221) étant réalisées à travers au moins une ouverture (146) formée à travers le capot (124).

24. Procédé selon l'une des revendications précédentes, comportant en outre, après la réalisation de couches d'interconnexions (126) du circuit intégré (104), la réalisation d'au moins une ouverture à travers les couches d'interconnexions (126) et le capot (124), formant un canal de communication entre le N/MEMS (122) et l'environnement extérieur.

25. Procédé selon l'une des revendications précédentes, le N/MEMS (122) étant réalisé par des étapes de photolithographie et de gravure dans la couche de semi-conducteur (116, 216).

26. Procédé selon la revendication 25, les étapes de photolithographie et de gravure réalisant le N/MEMS (122) formant légalement des tranchées d'isolation (115) autour du circuit intégré (104).

27. Procédé selon l'une des revendications précédentes, comportant en outre, avant la réalisation du N/MEMS (122), une étape de gravure du substrat (220), formant une zone inférieure et une zone supérieure, le N/MEMS (122) étant alors réalisé au niveau de la zone inférieure et le circuit intégré (104) étant réalisé au niveau de la zone supérieure.

28. Procédé selon la revendication 27, la face de la couche supérieure (116, 216) se trouvant du côté opposé au substrat (220) étant disposée entre un plan passant par la face du substrat (220) au niveau de la zone supérieure et un plan passant par la face du substrat (220) au niveau de la zone inférieure.

29. Dispositif (100, 200) comprenant :
- au moins un N/MEMS (122) réalisé dans au moins une couche supérieure (116, 216) disposée au moins au-dessus d'une première portion d'un substrat (120, 220),
- au moins un circuit intégré (104) réalisé dans une seconde portion du substrat (120, 220) et/ou dans une couche à base de semi-conducteur (116) disposée au moins au-dessus de la seconde portion du substrat (120, 220),
- un capot (124) encapsulant le N/MEMS (122),
**caractérisé en ce que** le capot (124) et une grille (114) du circuit intégré (104) sont à base d'un même matériau.

30. Dispositif (100, 200) selon la revendication 29, le circuit intégré (104) comportant au moins un transistor, la grille (114) du circuit intégré (104) comportant au moins une grille de transistor.

31. Dispositif (100, 200) selon l'une des revendications 29 ou 30, le capot (124) et la grille (114) du circuit intégré (104) étant à base d'au moins un même matériau électriquement conducteur.

32. Dispositif (100, 200) selon l'une des revendications 29 à 31, la couche supérieure (116, 216) et/ou la couche à base de semi-conducteur (116) disposée au-dessus de la seconde portion du substrat (120, 220) et/ou le substrat (120, 220) étant à base de silicium monocristallin.

33. Dispositif (100, 200) selon l'une des revendications 29 à 32, le substrat (220) comportant une zone inférieure et une zone supérieure, le N/MEMS (122) étant réalisé au niveau de la zone inférieure et le circuit intégré (104) étant réalisé au niveau de la zone supérieure.

34. Dispositif (100, 200) selon l'une des revendications 29 à 33, le N/MEMS (122) étant disposé dans une cavité (144) formée entre le substrat (120, 220) et le capot (124).

35. Dispositif (100, 200) selon l'une des revendications 29 à 34, le capot (124) étant recouvert par au moins une couche diélectrique (140) recouvrant également le circuit intégré (104) et à travers laquelle sont réalisés des contacts électriques (128, 130, 132, 134, 136, 138) reliés au circuit intégré et/ou à la couche de semi-conducteur (116, 216) et/ou au capot (124) et/ou au N/MEMS (122), et/ou aux couches d'interconnexions (126) également formées au dessus du circuit intégré (104).

## Patentansprüche

1. Verfahren zur Herstellung einer Vorrichtung (100, 200), die mindestens eine integrierte Schaltung (104) und mindestens ein N/MEMS (122) umfasst, das mindestens die folgenden Schritte umfasst:
- Herstellung des N/MEMS (122) in mindestens einer oberen Schicht (116, 216), die mindestens über einem ersten Abschnitt eines Substrats (120, 220) angeordnet ist,
- Herstellung der integrierten Schaltung (104) in einem zweiten Abschnitt des Substrats (120, 220) und/oder in einer Schicht auf Halbleiterbasis (116), die mindestens über dem zweiten Abschnitt des Substrats (120, 220) angeordnet ist, wobei das Verfahren **dadurch gekennzeichnet ist, dass** es ferner die Herstellung einer Kappe (124), die das N/MEMS (122) einkapselt, ausgehend von mindestens einer Schicht umfasst, die zur Herstellung eines Gates (114) der integrierten Schaltung (104) verwendet wird.

2. Verfahren nach Anspruch 1, wobei die obere Schicht (116, 216) auf mindestens einem Halbleiter basiert.

3. Verfahren nach Aspruch 2, wobei die obere Schicht (116) und die Halbleiterschicht (116), die über dem zweiten Abschnitt des Substrats (120) angeordnet ist, durch eine selbe Schicht auf Halbleiterbasis gebildet sind.

4. Verfahren nach einem der vorhergehenden Ansprüche, wobei die integrierte Schaltung (104) mindestens einen Transistor umfasst, wobei das Gate (114) der integrierten Schaltung (104) mindestens ein Transistor-Gate umfasst.

5. Verfahren nach Anspruch 4, wobei ein Kanal (109) des Transistors im zweiten Abschnitt des Substrats (120, 220) oder in der Halbleiterschicht (116) hergestellt ist, die über dem zweiten Abschnitt des Substrats (120, 220) angeordnet ist.

6. Verfahren nach einem der Ansprüche 4 bis 5, wobei der Transistor vom Typ MOSFET, MESFET, bipolar, FinFET, mit Dreifach-Gate, mit Gate-All-Around oder vom Typ lateraler MOS mit beweglichem Gate ist.

7. Verfahren nach einem der vorhergehenden Ansprüche, wobei die Kappe (124) und das Gate (114) der integrierten Schaltung (104) ausgehend von mindestens einer selben Schicht hergestellt sind, die auf einem elektrisch leitfähigen Material basiert.

8. Verfahren nach Anspruch 7, wobei die Kappe (124) und das Gate (114) durch Fotolithographie- und Ätzungsschritte der Schicht aus elektrisch leitfähigem Material hergestellt werden.

9. Verfahren nach einem der vorhergehenden Ansprüche, wobei das Gate (114) auf mindestens einem Metall und/oder Polysilizium basiert.

10. Verfahren nach einem der vorhergehenden Ansprüche, wobei die Kappe (124) auf dielektrischen Abschnitten (125) angeordnet ist, die von einer dielektrischen Schicht stammen, die zur Herstellung eines Gateoxids (112) der integrierten Schaltung (104) verwendet wird.

11. Verfahren nach einem der vorhergehenden Ansprüche, wobei die obere Schicht (116, 216) und/oder die Schicht auf Halbleiterbasis (116), die über dem zweiten Abschnitt des Substrats (120, 220) und/oder dem Substrat (120, 220) angeordnet ist, auf monokristallinem Silizium basiert/basieren.

12. Verfahren nach einem der vorhergehenden Ansprüche, wobei die Halbleiterschicht (116), die über dem zweiten Abschnitt des Substrats (120) und/oder der oberen Schicht (116) angeord-net ist, mit dem Substrat (120) ein Substrat des Typs SOI bildet, wobei die Halbleiterschicht (116), die über dem zweiten Abschnitt des Substrats (120) und/oder der oberen Schicht (116) angeordnet ist, die Oberflächenschicht des SOI-Substrats bildet.

13. Verfahren nach einem der vorhergehenden Ansprüche, wobei die Dicke der oberen Schicht (116, 216) und/oder der Schicht auf Halbleiterbasis (116), die über dem zweiten Abschnitt des Substrats (120, 220) angeordnet ist, kleiner als etwa 1 µm ist.

14. Verfahren nach einem der vorhergehenden Ansprüche, das ferner zwischen dem Schritt der Herstellung der Kappe (124) und einem Schritt der Herstellung von Verbindungsschichten (126) der integrierten Schaltung (104) einen Schritt der Herstellung von mindestens einer Schicht (140), die auf einem dielektrischen Material basiert, auf der Kappe (124) und auf der integrierten Schaltung (104) umfasst.

15. Verfahren nach Anspruch 14, das ferner zwischen dem Schritt der Herstellung der Schicht (140) aus dielektrischem Material und dem Schritt der Herstellung von Verbindungsschichten (126) einen Schritt der Herstellung von Kontakten (128, 130, 132, 134, 136, 138) umfasst, die auf mindestens einem elektrisch leitfähigen Material basieren, die elektrische Kontakte bilden, die mit der integrierten Schaltung (104) und/oder der Kappe (124) und/oder dem N/MEMS (122) verbunden sind.

16. Verfahren nach einem der vorhergehenden Ansprüche, wobei der Schritt der Herstellung der Kappe (124), auch mindestens eine Säule (142) zwischen der Kappe (124) und dem N/MEMS (122) bildet.

17. Verfahren nach einem der vorhergehenden Ansprüche, das ferner nach der Herstellung des N/MEMS (122) einen Schritt des Ätzens einer ersten Opferschicht (118, 219) umfasst, die sich zwischen der oberen Schicht (116, 216) und dem Substrat (120, 220) befindet.

18. Verfahren nach einem der vorhergehenden Ansprüche, das ferner nach der Herstellung der Kappe (124) einen Schritt des Ätzens einer zweiten Opferschicht (119, 221) umfasst, die sich zwischen der Kappe (124) und der Halbleiterschicht (116, 216) befindet.

19. Verfahren nach einem der vorhergehenden Ansprüche, das ferner nach der Herstellung der Kappe (124) einen Schritt des Ätzens eines Opfermaterials (117, 221) umfasst, das in Hohlräumen angeordnet ist, die in dem N/MEMS (122) und/oder um das N/MEMS (122) herum angeordnet sind.

20. Verfahren nach einem der Ansprüche 17 bis 19, wobei die erste Opferschicht (118, 219) und/oder die zweite Opferschicht (119, 221) und/oder das Opfermaterial (117, 221) auf mindestens einem Material basieren, das selektiv in Bezug zur oberen Schicht (116, 216) geätzt werden kann.

21. Verfahren nach einem der Ansprüche 17 bis 20, wobei die erste Opferschicht (118, 219) und/oder die zweite Opferschicht (119, 221) und/oder das Opfermaterial (117, 221) auf Siliziumoxid und/oder Silizium-Germanium basieren.

22. Verfahren nach Anspruch 21, wobei die erste Opferschicht (219) mindestens einen Silizium-Germaniumabschnitt im Bereich des Ortes des N/MEMS (122) umfasst, wobei der Rest der ersten Opferschicht (219) auf Siliziumoxid basiert.

23. Verfahren nach einem der Ansprüche 17 bis 22, wobei das Ätzen der ersten Opferschicht (118, 219) und/oder das Ätzen der zweiten Opferschicht (119, 221) und/oder das Ätzen des Opfermaterials (117, 221) durch mindestens eine Öffnung (146) ausgeführt wird, die durch die Kappe (124) hindurch gebildet ist.

24. Verfahren nach einem der vorhergehenden Ansprüche, das ferner nach der Herstellung von Verbindungsschichten (126) der integrierten Schaltung (104) die Herstellung von mindestens einer Öffnung durch die Verbindungsschichten (126) und die Kappe (124) umfasst, wodurch ein Verbindungskanal zwischen dem N/MEMS (122) und der äußeren Umgebung hergestellt wird.

25. Verfahren nach einem der vorhergehenden Ansprüche, wobei das N/MEMS (122) durch Fotolithographie- und Ätzungsschritte in der Halbleiterschicht (116, 216) hergestellt wird.

26. Verfahren nach Anspruch 25, wobei die Fotolithographie- und Ätzungsschritte, die das N/MEMS (122) herstellen, auch Isolationsgräben (115) um die integrierte Schaltung (104) herum bilden.

27. Verfahren nach einem der vorhergehenden Ansprüche, das ferner vor der Herstellung des N/MEMS (122) einen Schritt des Ätzens des Substrats (220) umfasst, wodurch eine untere Zone und eine obere Zone gebildet werden, wobei das N/MEMS (122) dann im Bereich der unteren Zone hergestellt wird und die integrierte Schaltung (104) im Bereich der oberen Zone hergestellt wird.

28. Verfahren nach Anspruch 27, wobei die Fläche der oberen Schicht (116, 216), die sich auf der dem Substrat (220) gegenüberliegenden Seite befindet, zwischen einer Ebene, die durch die Fläche des Substrats (220) im Bereich der oberen Zone verläuft, und einer Ebene angeordnet ist, die durch die Fläche des Substrats (220) im Bereich der unteren Zone verläuft.

29. Vorrichtung (100, 200), die Folgendes umfasst:
- mindestens ein N/MEMS (122), das in mindestens einer oberen Schicht (116, 216) hergestellt ist, die mindestens über einem ersten Abschnitt des Substrats (120, 220) angeordnet ist,
- mindestens eine integrierte Schaltung (104), die in einem zweiten Abschnitt des Substrats (120, 220) und/oder in einer Schicht auf Halbleiterbasis (116) hergestellt ist, die mindestens über dem zweiten Abschnitt des Substrats (120, 220) angeordnet ist,
- eine Kappe (124), die das N/MEMS (122) einkapselt,
**dadurch gekennzeichnet, dass** die Kappe (124) und ein Gate (114) der integrierten Schaltung (104) auf einem selben Material basieren.

30. Vorrichtung (100, 200) nach Anspruch 29, wobei die integrierte Schaltung (104) mindestens einen Transistor umfasst, wobei das Gate (114) der integrierten Schaltung (104) mindestens ein Transistor-Gate umfasst.

31. Vorrichtung (100, 200) nach einem der Ansprüche 29 oder 30, wobei die Kappe (124) und das Gate (114) der integrierten Schaltung (104) auf mindestens einem selben, elektrisch leitfähigen Material basieren.

32. Vorrichtung (100, 200) nach einem der Ansprüche 29 bis 31, wobei die obere Schicht (116, 216) und/oder die Schicht auf Halbleiterbasis (116), die über dem zweiten Abschnitt des Substrats (120, 220) und/oder dem Substrat (120, 220) angeordnet ist/sind, auf monokristallinem Silizium basiert/basieren.

33. Vorrichtung (100, 200) nach einem der Ansprüche 29 bis 32, wobei das Substrat (220) eine untere Zone und eine obere Zone umfasst, wobei das N/MEMS (122) im Bereich der unteren Zone hergestellt ist und die integrierte Schaltung (104) im Bereich der oberen Zone hergestellt ist.

34. Vorrichtung (100, 200) nach einem der Ansprüche 29 bis 33, wobei das N/MEMS (122) in einem Hohlraum (144) angeordnet ist, der zwischen dem Substrat (120, 220) und der Kappe (124) gebildet ist.

35. Vorrichtung (100, 200) nach einem der Ansprüche 29 bis 34, wobei die Kappe (124) durch mindestens eine dielektrische Schicht (140) bedeckt ist, die auch die integrierten Schaltung (104) bedeckt, und über die elektrische Kontakte (128, 130, 132, 134, 136, 138) hergestellt sind, die mit der integrierten Schaltung und/oder der Halbleiterschicht (116, 216) und/oder der Kappe (124) und/oder dem N/MEMS (122) und/oder den Verbindungsschichten (126) verbunden sind, die auch über der integrierten Schaltung (104) gebildet sind.

## Claims

1. Method for production of a device (100, 200) comprising at least one integrated circuit (104) and at least one N/MEMS (122), comprising at least the steps of:
- production of the N/MEMS (122) in at least one upper layer (116, 216) arranged at least above a first portion of a substrate (120, 220),
- production of the integrated circuit (104) in a second portion of the substrate (120, 220) and/or in a layer based on semiconductor (116) arranged at least above the second portion of the substrate (120, 220),
method **characterized in that** it further comprises the production of a cover (124) encapsulating the N/MEMS (122) from at least one layer used for the production of a gate (114) of the integrated circuit (104).

2. Method according to claim 1, the upper layer (116, 216) being based on at least one semiconductor.

3. Method according to claim 2, the upper layer (116) and the semiconductor layer (116) arranged above the second portion of the substrate (120) being formed by a same layer based on semiconductor.

4. Method according to one of the preceding claims, the integrated circuit (104) comprising at least one transistor, the gate (114) of the integrated circuit (104) comprising at least one transistor gate.

5. Method according to claim 4, a channel (109) of the transistor being formed in the second portion of the substrate (120, 220) or in the semiconductor layer (116) arranged above the second portion of the substrate (120, 220).

6. Method according to one of claims 4 or 5, the transistor being of the MOSFET, MESFET, bipolar, FinFET, triple gate, gate all round type, or lateral MOS with movable gate type.

7. Method according to one of the preceding claims, the cover (124) and the gate (114) of the integrated circuit (104) being formed from at least one same layer based on an electrically conducting material.

8. Method according to claim 7, the cover (124) and the gate (114) being formed by steps of photolithography and etching of the layer of electrically conductive material.

9. Method according to one of the preceding claims, the gate (114) being based on at least one metal and/or polysilicon.

10. Method according to one of the preceding claims, the cover (124) being arranged on dielectric portions (125) stemming from a dielectric layer used for the production of a gate oxide (112) of the integrated circuit (104).

11. Method according to one of the preceding claims, the upper layer (116, 216) and/or the layer based on semiconductor (116) arranged above the second portion of the substrate (120, 220) and/or the substrate (120, 220) being based on monocrystalline silicon.

12. Method according to one of the preceding claims, the semiconductor layer (116) arranged above the second portion of the substrate (120) and/or the upper layer (116) forming, with the substrate (120), a SOI type substrate, the semiconductor layer (116) arranged above the second portion of the substrate (120) and/or the upper layer (116) forming the superficial layer of the SOI substrate.

13. Method according to one of the preceding claims, the thickness of the upper layer (116, 216) and/or the layer based on semiconductor (116) arranged above the second portion of the substrate (120, 220) being less than around 1 µm.

14. Method according to one of the preceding claims, further comprising, between the step of production of the cover (124) and a step of production of interconnection layers (126) of the integrated circuit (104), a step of production of at least one layer (140) based on a dielectric material on the cover (124) and on the integrated circuit (104).

15. Method according to claim 14, further comprising, between the step of production of the layer (140) of dielectric material and the step of production of the interconnection layers (126), a step of production of contacts (128, 130, 132, 134, 136, 138) based on at least one electrically conductive material forming electrical contacts connected to the integrated circuit (104) and/or to the cover (124) and/or to the N/MEMS (122).

16. Method according to one of the preceding claims, the step of production of the cover (124) also forming at least one pillar (142) between the cover (124) and the N/MEMS (122).

17. Method according to one of the preceding claims, further comprising, after the production of the N/MEMS (122), a step of etching a first sacrificial layer (118, 219) located between the upper layer (116, 216) and the substrate (120, 220).

18. Method according to one of the preceding claims, further comprising, after the production of the cover (124), a step of etching a second sacrificial layer (119, 221) located between the cover (124) and the semiconductor layer (116, 216).

19. Method according to one of the preceding claims, further comprising, after the production of the cover (124), a step of etching a sacrificial material (117, 221) arranged in cavities formed in the N/MEMS (122) and/or around the N/MEMS (122).

20. Method according to one of claims 17 to 19, the first sacrificial layer (118, 219) and/or the second sacrificial layer (119, 221) and/or the sacrificial material (117, 221) being based on at least one material that may be etched selectively compared to the upper layer (116, 216).

21. Method according to one of claims 17 to 20, the first sacrificial layer (118, 219) and/or the second sacrificial layer (119, 221) and/or the sacrificial material (117, 221) being based on silicon oxide and/or silicon-germanium.

22. Method according to claim 21, the first sacrificial layer (219) comprising at least one portion of silicon-germanium at the position of the N/MEMS (122), the remainder of the first sacrificial layer (219) being based on silicon oxide.

23. Method according to one of claims 17 to 22, the etching of the first sacrificial layer (118, 219) and/or the etching of the second sacrificial layer (119, 221) and/or the etching of the sacrificial material (117, 221) being carried out through at least one opening (146) formed through the cover (124).

24. Method according to one of the preceding claims, further comprising, after the production of interconnection layers (126) of the integrated circuit (104), the production of at least one opening through the interconnection layers (126) and the cover (124), forming a communication channel between the N/MEMS (122) and the exterior environment.

25. Method according to one of the preceding claims, the N/MEMS (122) being formed by steps of photolithography and etching in the semiconductor layer (116, 216).

26. Method according to claim 25, the photolithography and etching steps forming the N/MEMS (122) also forming insulation trenches (115) around the integrated circuit (104).

27. Method according to one of the preceding claims, further comprising, before the production of the N/MEMS (122), a step of etching the substrate (220), forming a lower zone and an upper zone, the N/MEMS (122) then being formed at the level of the lower zone and the integrated circuit (104) being formed at the level of the upper zone.

28. Method according to claim 27, the face of the upper layer (116, 216) located on the side opposite to the substrate (220) being arranged between a plane passing through the face of the substrate (220) at the level of the upper zone and a plane passing through the face of the substrate (220) at the level of the lower zone.

29. Device (100, 200) comprising:
- at least one N/MEMS (122) formed in at least one upper layer (116, 216) arranged at least above a first portion of a substrate (120, 220),
- at least one integrated circuit (104) formed in a second portion of the substrate (120, 220) and/or in a layer based on semiconductor (116) arranged at least above the second portion of the substrate (120, 220),
- a cover (124) encapsulating the N/MEMS (122),
**characterized in that** the cover (124) and a gate (114) of the integrated circuit (104) are based on at least one same material.

30. Device (100, 200) according to claim 29, the integrated circuit (104) comprising at least one transistor, the gate (114) of the integrated circuit (104) comprising at least one transistor gate.

31. Device (100, 200) according to one of claims 29 or 30, the cover (124) and the gate (114) of the integrated circuit (104) being based on at least one same electrically conducting material.

32. Device (100, 200) according to one of claims 29 to 31, the upper layer (116, 216) and/or the layer based on semiconductor (116) arranged above the second portion of the substrate (120, 220) and/or the substrate (120, 220) being based on monocrystalline silicon.

33. Device (100, 200) according to one of claims 29 to 32, the substrate (220) comprising a lower zone and an upper zone, the N/MEMS (122) being formed at the level of the lower zone and the integrated circuit (104) being formed at the level of the upper zone.

34. Device (100, 200) according to one of claims 29 to 33, the N/MEMS (122) being arranged in a cavity (144) formed between the substrate (120, 220) and the cover (124).

35. Device (100, 200) according to one of claims 29 to 34, the cover (124) being covered by at least one dielectric layer (140) also covering the integrated circuit (104) and through which are formed electrical contacts (128, 130, 132, 134, 136, 138) connected to the integrated circuit and/or to the semiconductor layer (116, 216) and/or to the cover (124) and/or to the N/MEMS (122), and/or to the interconnection layers (126) also formed above the integrated circuit (104).
